(19) Europäisches Patentamt
European Patent Office
Office européen des brevets

(11) **EP 2 309 649 A1**

(12) **EUROPEAN PATENT APPLICATION**

(43) Date of publication:
**13.04.2011  Bulletin 2011/15**

(51) Int Cl.:
**H03M 13/15** $^{(2006.01)}$

(21) Application number: **09171077.2**

(22) Date of filing: **23.09.2009**

| | |
|---|---|
| (84) Designated Contracting States:<br>**AT BE BG CH CY CZ DE DK EE ES FI FR GB GR HR HU IE IS IT LI LT LU LV MC MK MT NL NO PL PT RO SE SI SK SM TR**<br>Designated Extension States:<br>**AL BA RS** | (72) Inventors:<br>• **Brauchle, Joschi Tobias**<br>　**81541 München (DE)**<br>• **Kötter, Ralf**<br>　**80634 Munich (DE)** |
| (71) Applicant: **Rohde & Schwarz GmbH & Co. KG**<br>**81671 München (DE)** | (74) Representative: **Körfer, Thomas et al**<br>**Mitscherlich & Partner**<br>**Patent- und Rechtsanwälte**<br>**Sonnenstrasse 33**<br>**80331 München (DE)** |

(54) **A systematic encoder with arbitrary parity positions**

(57)　An encoder structure for an error correcting code with arbitrary parity positions is presented. The invention is effective for all error correcting codes whose parity check matrix is of the Vandermonde type. In contrast to conventional encoder circuits, the parity symbols produced by this encoder are not restricted to form a block of consecutive parity symbols at the beginning or at the end of a codeword, but may be spread arbitrarily within the codeword. A general structure of the parity check matrix for such a code is found by exploiting the special Vandermonde structure of matrices. From this general parity check matrix, an expression for the evaluation of the parity symbols in terms of a polynomial with limited degree is derived. An efficient hardware implementation of the proposed encoder is suggested.

Fig. 2

EP 2 309 649 A1

## Description

## Technical Field

The present invention relates to an encoding circuit for data transmission from a source to a destination over a communication channel by means of an error-correcting code.

## Background and State of the Art

Reliable data transmission over a communication channel is fundamental in all fields of information and communication technology. Unfortunately, most communication channels in the real world are noisy, so that the signal is distorted on its way from the sender to the receiver. Signal distortions can be due both to imperfections of the sender and/or receiver equipment, or to external influences during transmission. Error-correcting codes have been developed to identify and correct such errors, so that, after correction, the recipient receives a (nearly) exact copy of the data transmitted by the sender with a high level of certainty. Typically, the particular code is chosen based on some information about the infidelities of the channel through which the data is transmitted, as well as the nature of the data.

A class of error-correcting codes with high practical relevance are Reed-Solomon error-correcting codes, which protect messages by constructing a polynomial from the raw data. The polynomial is evaluated at several points, and these values are sent or recorded. Sampling the polynomial more often than necessary makes the polynomial overdetermined, and as long as the recipient sufficiently many of these points correctly, she or he can recover the original polynomial even in the presence of transmission errors. Reed-Solomon codes are used in a wide variety of commercial applications, both for data storage on CDs, DVDs and blue ray discs as well as in broadcast systems such as digital television. They are particularly efficient to protect against burst errors, in which a whole train of subsequent data symbols is corrupted.

Reed-Solomon error-correcting codes can be encoded as "systematic codes", i.e., the codeword contains the input data in its original form plus some parity symbols. The values of the parity symbols allow the decoder to determine whether the data has been lost or corrupted during transmission, and to correct for transmission errors. In conventional systematic Reed-Solomon encoding schemes, a block of parity symbols is simply appended or pre-appended to the unaltered block of data symbols.

In contrast, the upcoming ATSC mobile/handheld digital television standard (ATSC-M/H) is based on a Reed-Solomon code in which the parity symbols are no longer arranged in a block of consecutive symbols, but may be spread arbitrarily within the codeword. Section 5.4.9 and Table A.1 of the specification "ATSC-M/H Standard, Part 2, RF/Transmission System Characteristics (A/153, Part 2: 2009)", published by the Advanced Television Systems Committee, suggest a systematic $t= 10$ error-correcting Reed-Solomon code of length $n=207$ and dimension $k=n-2 \times t=187$ defined over the finite field $IF_{256}$. The $2 \times t = 20$ parity symbols are supposed to be inserted according to one out of 118 different parity patterns, which specify the positions of the parity symbols in the codeword. These parity positions may differ from codeword to codeword. Conventional encoding circuits are adapted to codewords in which the parity symbols are arranged blockwise at fixed positions, and hence cannot be used to provide codewords with arbitrary parity positions.

## Object of the Present Invention

It is hence the object of the present invention to provide an encoder which allows to efficiently and quickly produce codewords with parity positions according to any predefined parity pattern.

## Summary of the Invention

This objective is achieved by a method of encoding data with the features of independent claim 1 as well as by providing an encoder with the features of independent apparatus claim 11. The dependent claims relate to preferred embodiments.

The method of encoding data for transmission from a source to a destination over a communication channel by means of an error-correcting code according to the present invention comprises the steps of receiving a plurality of data symbols and preparing at least one codeword of said error-correcting code at an encoding station, said codeword to be transmitted over said communication channel and comprising said plurality of data symbols and a plurality of parity symbols. Said step of preparing said codeword comprises the steps of selecting one out of a plurality of parity patterns, said parity pattern determining the positions at which said parity symbols are located within said codeword, and determining said parity symbols on the basis of said data symbols and said selected parity pattern, characterized in that determining at least one of said parity symbols is based on a step of evaluating a polynomial of a degree that is no larger than the number of parity symbols in said codeword.

It is the surprising finding of the present invention that the step of determining the parity symbols at arbitrary parity positions can be reduced to the evaluation of a polynomial of a degree that is no larger than the number of parity symbols, Evaluation of such a polynomial is fast, can be implemented efficiently and requires only very limited hardware and storage capabilities. This allows the encoder to determine the parity symbols and to produce the corresponding codewords for transmission "on the fly", i.e., as the data symbols are received by the encoder. As a result, the encoding rate, and hence the transfer rate at which signals can be sent from the receiver to the recipient can be enhanced. At the same time, the hardware and storage requirements for implementing the encoder are reduced.

The present invention is not limited to Reed-Solomon codes, but is effective at least whenever the error-correcting code is defined by a parity check matrix having a Vandermonde structure, i.e., whenever the parity check matrix H or its transpose satisfy the equation $(H_{ij})_{ij} = \alpha^{ij}$ for some element $\alpha$, $i = 0, ..., 2 \cdot t-1$; $j = 0, ..., n-1$.

According to a preferred embodiment, said polynomial is a Lagrange polynomial, i.e.

$$\Lambda^{(j)}(\alpha^{i_k}) = \begin{cases} 1 \, for \, k=j, \\ 0 \, for \, k \neq j, \end{cases} \qquad (1)$$

wherein $\alpha$ denotes the primitive element of a finite field, $j$ is a positive integer denoting the parity symbol, and $i_k$ is a positive integer denoting the position of the k-th parity symbol in said codeword according to said selected parity pattern.

It is a finding of the present invention that the step of determining said parity symbols can be reduced to the step of evaluating a Lagrange polynomial. Due to the simple form of this polynomial, the efficiency of determining the parity symbols can be further enhanced.

In a preferred embodiment, the $j$-th parity symbol can be determined by evaluating the equation

$$P_j = \sum_{\ell=0}^{n-1} \hat{c}_\ell \cdot \Lambda^{(j)}(\alpha^\ell). \qquad (2)$$

for every parity symbol $P_j$, where $n$ denotes the length of said codeword, $A^{(j)}$ denotes a polynomial of a degree that is no larger than the number of parity symbols in said codeword, $\alpha$ denotes the primitive element of a finite field, and $\tilde{c}\ell$ equals the data symbol at positions $\ell$ of said codeword if $\ell$ does not denote a position of a parity symbol in said codeword, or equals 0 if $\ell$ denotes a position of a parity symbol in said codeword.

According to a further embodiment, said step of determining said parity symbols comprises a step of evaluating said polynomial of a degree no larger than the number of parity symbols, and further evaluating its derivative, wherein said polynomial is independent of said parity symbols.

It is the surprising finding of the inventors that the step of determining said parity symbols can be based on the step of evaluating a polynomial which is one and the same for all the parity symbols to be determined. According to this embodiment, only a single polynomial needs to be evaluated to determine the plurality of parity symbols in said codeword. Accordingly, the speed and efficiency of the encoding circuit can be further enhanced.

In a further embodiment, said step of determining said parity symbols comprises a step of evaluating a ratio of said polynomial at an element of a finite field and said element itself, and further evaluating said derivative of said polynomial.

According to a preferred embodiment, said plurality of parity symbols are solely defined in terms of the roots of said polynomial and the position of the parity symbol within said codeword.

In further embodiment, the $j$-th parity symbol is determined by evaluating the equation

$$P_j = \frac{1}{\Lambda'(\alpha^{i_j})} \cdot \sum_{\ell=0}^{n-1} \hat{c}_\ell \cdot \frac{\Lambda(\alpha^\ell)}{\alpha^\ell} \cdot \frac{1}{1-\alpha^{i_j-\ell}} \qquad (3)$$

for every parity symbol $P_j$, wherein $n$ denotes the length of said codeword, A denotes a polynomial of the degree that is no larger than the number of parity symbols and said codeword, said polynomial $\Lambda$ being independent of said parity symbols $P_j$, $\alpha$ denotes the primitive element of a finite field, $\Lambda'$ denotes the first derivative of $\Lambda$, $i_j$ is positive integer

denoting the position of the *j*-th parity symbol in said codeword, and $\hat{c}_\ell$ equals the data symbol at position $\ell$ of said codeword if $\ell$ does not denote a position of a parity symbol in said codeword, or equals 0 if $\ell$ denotes the position of a parity symbol in said codeword.

According to the latter embodiment, each parity symbol $P_j$ can be determined by evaluating a polynomial A which is independent of the position $i_j$ of the parity symbol in said codeword, and by further evaluating its derivative $\Lambda'$ on an element $\alpha^{i_j}$ that depends on the position of the corresponding parity symbol in said codeword. The remaining terms in Eq. (3) are likewise easy and quick to evaluate, and hence the step of determining the parity symbols reduces to a sequence of standard operations for which an efficient implementation exists.

According to a preferred embodiment, said parity symbols are not arranged in a single block at the beginning or the end of said codeword. The method of the present invention allows to produce encrypted codewords with parity symbols that may be spread arbitrarily within said codewords,

According to a further embodiment, said parity symbols are determined by means of a Chien search. A Chien search provides a very efficient architecture for evaluating said polynomial of a degree no larger than a number of parity symbols in said codeword, and simultaneously evaluating its derivative.

The invention also relates to a storage medium storing instructions readable by a computing device, such that the computing device, when executing said instructions, implements a method with some or all of the features described above.

The invention further relates to an encoder for encoding data to be transmitted from a source to a destination over a communication channel by means of an error-correcting code, said error-correcting code being defined by a parity check matrix having a Vandermonde structure, wherein said encoder comprises encoding means adapted to receive a plurality of data symbols and to prepare at least one codeword of said error-correcting code, said codeword to be transmitted over said communication channel and comprising said plurality of data symbols and a plurality of parity symbols. The encoder further comprises pattern selection means adapted to select one out of a plurality of parity patterns, said parity pattern determining the positions at which said parity symbols are located within said codeword, characterized in that said encoder is adapted to determine said parity symbols on the basis of said data symbols and said selected parity pattern by evaluating a polynomial of a degree that is no larger than the number of parity symbols in said codeword.

As described above, an encoder according to the present invention allows the quick and efficient encoding of codewords with arbitrary parity positions.

According to a preferred embodiment, said encoder is adapted to determine said parity symbols by evaluating said polynomial and further evaluating its derivative, said polynomial being independent of said parity symbols.

In a further embodiment, said encoder is adapted to determine said parity symbols by evaluating a ratio of said polynomial at an element of a finite field and said element itself, and further evaluating said derivative of said polynomial.

In a preferred embodiment, the encoder comprises a first summing circuit, a second summing circuit, and a third summing circuit, said third summing circuit connecting an output line of said first summing circuit to an output line of said second summing circuit, wherein said first summing circuit comprises a plurality of first registers adapted to hold a plurality of even powers of a primitive element of a finite field and a corresponding number of first coefficients, said second summing circuit comprises a plurality of second registers adapted to hold a plurality of odd powers of said primitive element and a corresponding number of second coefficients, and said third summing circuit is adapted to add an output of said first summing circuit to an output of said second summing circuit.

The encoder according to the latter embodiment takes into account that both the terms $\Lambda(x)/x$ and $\Lambda'(x)$ evaluated in determining the parity symbols share monomials comprising the even powers of x. The circuit architecture according to the latter embodiment allows to evaluate the even powers of the primitive element in the first summing circuit, and to simultaneously evaluate the odd powers in the second summing circuit. By adding an output of said first summing circuit to an output of said second summing circuit in said third summing circuit, both terms required for evaluating the value of the parity symbols can be computed simultaneously and with minimal resources, and the overall efficiency of the circuit is further enhanced.

According to a further embodiment, the encoder comprises an inversion circuit adapted to invert the output of said first summing circuit.

## Detailed Description of a Preferred Embodiment

The numerous features and advantages of the present invention will now be described with reference to the accompanying figures, in which:

Fig. 1    is a schematic circuit diagram illustrating the simultaneous evaluation of the parity locator polynomial and its derivative in a Chien search; and

Fig. 2    is a schematic hardware circuit of an encoder according to the present invention.

The method and system according to the present invention are effective whenever data is to be transmitted from a source to a destination over a communication channel by means of an error-correcting code defined by a parity check matrix with the Vandermonde structure. The communication channel may model data transmission both through space and/or through time, such as data transmitted from one location to another or data stored at one time and used at another. Channels in space can be wires, networks, fibers, wireless media etc. between a sender and a receiver. Channels in time can be data storage devices such as CDs or DVDs. The channel is a description or model for the transformation the data undergoes on its way from a source (or sender) to a destination (or receiver) separated in time and/or space.

For concreteness, the invention will now be described in further detail for the example of a systematic Reed-Solomon code over a finite field. However, it will be apparent to those skilled in the art that the invention is not limited to such codes.

1. Definition of a Systematic Reed-Solomon Code

Let $\{\alpha^0, \alpha^1, ..., \alpha^{n-1}\} \in IF_q$ be a set of $n < q$ distinct and nonzero elements of a finite field $IF_q$, where the positive integer $q$ denotes the size of the field $IF_q$. A t-error-correcting Reed-Solomon code (RS code) of length $n$ and dimension $k$ over the field $IF_q$ may be defined as

$$\mathcal{C}_{\mathrm{RS}} = \left\{ \underline{c} \in \mathrm{IF}_q^n : \sum_{i=0}^{n-1} c_i \alpha^{i \cdot j} = 0, \quad j = 0, \dots, 2t - 1 \right\}, \qquad (4)$$

where $t$ and $k$ are positive integers satisfying the relation $2t = n - k$. The elements $\alpha^i \in IF_q$, $i = 0, ..., n - 1$, are consecutive powers of the primitive element $\alpha$ of $IF_q$ and commonly called "code locators". In digital communications, the field size $q$ is often restricted to powers of 2, so that all elements of $IF_q$, $q = 2^m$, can be uniquely represented by a vector of $m$ bits.

For instance, the error-correcting code suggested for the upcoming ATSC mobile/handheld digital television standard is a systematic $t=10$ error-correcting Reed-Solomon code of length $n=207$ and dimension $k=n-2\cdot t=187$, defined over the finite field $IF_{256}$. However, the method and system according to the invention can be applied to codes of other lengths $n$ and other dimensions $k$.

As Reed-Salamon codes are linear block codes, they can be expressed as the set of all vectors $\underline{c} \in \mathbb{F}_q^n$ lying in the null space of a parity check matrix $H$, i.e.,

$$\mathcal{C}_{\mathrm{RS}} = \left\{ \underline{c} \in \mathrm{IF}_q^n : H\underline{c}^T = \underline{0} \right\}. \qquad (5)$$

The codeword $\underline{c}$ of total length $n$ comprises $k$ data symbols to be transmitted, as well as $2\cdot t$ parity symbols used to identify and correct transmission errors. A parity check matrix of this Reed-Solomon code,

$$H = \begin{pmatrix} 1 & 1 & 1 & \dots & 1 \\ \alpha^0 & \alpha^1 & \alpha^2 & \dots & \alpha^{n-1} \\ \vdots & \vdots & \vdots & & \vdots \\ \alpha^{0 \cdot (2t-1)} & \alpha^{1 \cdot (2t-1)} & \alpha^{2 \cdot (2t-1)} & \dots & \alpha^{(n-1) \cdot (2t-1)} \end{pmatrix}, \qquad (6)$$

is a $2t \times n$ Vandermonde matrix, where each column $\underline{h}^T_i$ consists of $2t$ consecutive powers of the corresponding code locator element $\alpha^i$ for $i = 0, ..., n - 1$. In matrix notation, $(H_{ji}) = \alpha^{i \cdot j}$ for the primitive element $\alpha \in IF_q$; $i=0, ..., n-1$; $j=0, ..., 2t-1$.

For any linear code C there always exists an equivalent systematic code $C_{sys}$, producing codewords of the form

$$c_{sys} = (I_0, I_1, ..., I_{k-1}, P_0, P_1, ..., P_{2t-1})  \qquad (7)$$

where $I_\ell$, $\ell=0, ..., k-1$ denote $k$ consecutive data symbols, and $P_j$, $j=0, ..., 2t-1$ denote the parity symbols of the codeword $c_{sys}$. Eq. (7) represents codewords of a conventional RS code, in which all the parity symbols are grouped into a single block, and are appended to the block of data symbols. Alternatively, in a conventional RS code the block of parity symbols may also be pre-appended to the block of data symbols.

Combining Equations (5) and (7), a systematic parity check matrix $H_{sys}$ may be given the form,

$$H_{sys} = (\,P \mid I_{2t}\,) = \begin{pmatrix} & P & \begin{vmatrix} 1 & \cdots & 0 \\ \vdots & \ddots & \vdots \\ 0 & \cdots & 1 \end{vmatrix} \end{pmatrix} \qquad (8)$$

where $I_{2t}$ denotes a $2t \times 2t$ identity matrix. The submatrix P that defines the parity check relations can be found by translating the original (non-systematic) parity check matrix $H = (A \mid B_{2t})$ into its equivalent systematic form $H_{sys}$ by left-multiplying $H$ with the inverse $B_{2t}^{-1}$ of the submatrix $B_{2t}$,

$$H_{sys} = B_{2t}^{-1}\, H, \quad \text{and hence} \quad P = B_{2t}^{-1}\, A. \qquad (9)$$

Due to its origin as a submatrix of $H$, $B_{2t}$ is a $2t \times 2t$ Vandermonde matrix as well. As long as the code locator elements $\alpha^i$ are distinct and nonzero, a Vandermonde matrix is of full rank and nonsingular. Consequently, $B_{2t}$ will be nonsingular, and its inverse $B_{2t}^{-1}$ will exist.

## 2. A Systematic Reed-Solomon Code with Arbitrary Parity Positions

According to the upcoming ATSC mobile/handheld digital television standard, parity symbols may no longer be appended or pre-appended in a single block to the block of data symbols, but may be located at arbitrary positions $i_j \in [0, n-1]$, $j= 0, ..., 2t - 1$, within a codeword $\tilde{c}_{RS}$, e.g.

$$\tilde{c}_{RS} = (I_0, I_1, \ldots, P_0, \ldots, P_1, \ldots, P_{2t-1}, \ldots, I_{k-1}). \qquad (10)$$

The set $\{i_j\}_{j=0, ..., 2t-1}$ defines a parity pattern, i.e., a set of positions at which the parity symbols $P_j$ are located within the codeword $\underline{c}_{RS}$. Together with the data symbols, one of a plurality of parity patterns $\{i_j\}_{j=0, ..., 2t-1}$ is selected and received at the encoding station. The encoder then needs to determine a codeword $\underline{c}_{RS}$ with the selected parity pattern and hence its parity symbols $(P_j)_{j=0, ..., 2t-1}$ on the basis of the data symbols $(I\ell)_{\ell=0, ..., k-1}$ and the selected parity pattern $\{i_j\}_{j=0, ..., 2t-1}$. To this end, the parity check matrix can be transformed to the form

$$\widetilde{H} = \left( P \ldots \begin{vmatrix} 1 \\ 0 \\ \vdots \\ 0 \end{vmatrix} \ldots P' \ldots \begin{vmatrix} 0 \\ 1 \\ \vdots \\ 0 \end{vmatrix} \ldots P'' \ldots \begin{vmatrix} 0 \\ 0 \\ \vdots \\ 1 \end{vmatrix} \ldots P''' \right) \qquad (11)$$

$$\text{code locator index} = \qquad i_0 \qquad\qquad i\ell \qquad\qquad i_{2t\text{-}1}$$

where the locations $i_j$ of the canonical unit vectors $\underline{e}_j$ within $\widetilde{H}$ specify the locations of the parity symbols $P_j$ within the codeword $\underline{C}_{RS}$. As in Eq. (9) above, $\widetilde{H}$ can be expressed in terms of $H$ and some matrix $\widetilde{B}$, such that

$$\widetilde{H} = \widetilde{B}^{-1} H. \qquad (12)$$

To satisfy this relationship, the matrix $\widetilde{B}$ must be composed of the columns $\underline{h}_{i_0}^T, \ldots, \underline{h}_{i_{2t-1}}$ of the original H, i.e.,

$$\widetilde{B} = \left( \underline{h}_{i_0}^T \quad \underline{h}_{i_1}^T \quad \ldots \quad \underline{h}_{i_{2t-1}}^T \right)$$

$$= \begin{pmatrix} 1 & 1 & \ldots & 1 \\ \alpha^{i_0} & \alpha^{i_1} & \ldots & \alpha^{i_{2t-1}} \\ \vdots & \vdots & & \vdots \\ \alpha^{i_0 \cdot (2t-1)} & \alpha^{i_1 \cdot (2t-1)} & \ldots & \alpha^{i_{2t-1} \cdot (2t-1)} \end{pmatrix}$$

$$(13)$$

From Eq. (13) it can be seen that $\widetilde{B}$ is again a *2t* x *2t* Vandermonde matrix consisting of distinct elements $\alpha^{ij}$, thus its inverse $\widetilde{B}^{-1}$ is guaranteed to exist.

Based on these considerations, a rather straightforward (but inefficient) way of determining the parity symbols of a Reed-Solomon code with arbitrary parity positions would be an inversion of the transfer matrix $\widetilde{B}$ for each of the relevant parity patterns. The parity check matrix $\widetilde{H}$ could then be computed according to Eq. (12). However, the inversion of a (large) matrix $\widetilde{B}$ is computationally rather complex and requires a lot of resources. It cannot be performed "on the fly", as the data symbols to be transmitted arrive at the encoder. Hence, the inverses $\widetilde{B}^{-1}$ would need to be pre-computed and stored at the encoding station for each of the plurality of different parity patterns that may be selected for encryption. There may be many different such parity patterns. For instance, the ATSC-M/H Standard prescribes 118 different patterns, resulting in total storage requirements of

$$(118 \text{ patterns}) \times (187 \text{ columns/pattern}) \times (20 \text{ bytes/column}) = 420{,}080 \text{ bytes.} \qquad (14)$$

### 3. Efficient Determination of the Parity Symbols

As explained above, the two biggest obstacles in finding an efficient and compact encoder are the computationally very complex inversion of $\tilde{B}$ on the one hand, and the storage requirements for $\tilde{H}$ on the other. It is the surprising finding of the present invention that both obstacles can be circumvented by exploiting the special Vandermonde structure of the parity check matrix. The idea is to make use of the fact that the inner product of some arbitrary vector

$$\underline{a} = (a_0, a_1, a_2, \ldots, a_{2t-1}) \in \mathrm{IF}_q^{2t} \tag{15}$$

and a Vandermonde vector $\underline{v}$, consisting of $2t$ consecutive powers of $\alpha^{i_j}$,

$$\underline{v} = \left(1, \alpha^{1 \cdot i_j}, \alpha^{2 \cdot i_j}, \ldots, \alpha^{(2t-1) \cdot i_j}\right) \in \mathrm{IF}_q^{2t}, \tag{16}$$

i.e.,

$$<\underline{a}, \underline{v}> = a_0 + a_1 \cdot \alpha^{1 \cdot i_j} + a_2 \cdot \alpha^{2 \cdot i_j} + \ldots + a_{2t-1} \cdot \alpha^{(2t-1) \cdot i_j} = A(\alpha^{i_j}), \tag{17}$$

is equivalent to the evaluation of a poynominal $A(x) \in \mathit{IF}_q[x]$ of degree $2t - 1$ and coefficient vector $\underline{a}$ with the element $\alpha^{i_j}$. $\mathit{IF}_q[x]$ denotes the ring of polynominals with coefficients from the field $\mathit{IF}_q$.

The inner product of the $j$-th row of $\tilde{B}^{-1}$, denoted by $\underline{\lambda}^{(j)}$, and the $\ell$-th column $\underline{h}_\ell^T$ of H results in in

$$<\underline{\lambda}^{(j)}, \underline{h}_\ell> = \lambda_0^{(j)} \cdot 1 + \lambda_1^{(j)} \cdot \alpha^\ell + \ldots + \lambda_{2t-1}^{(j)} \cdot \alpha^{\ell \cdot (2t-1)} = \Lambda^{(j)}(\alpha^\ell), \tag{18}$$

and with this insight, Eq. (12) becomes

$$\tilde{H} = \tilde{B}^{-1} H$$

$$= \begin{pmatrix} \lambda_0^{(0)} & \lambda_1^{(0)} & \cdots & \lambda_{2t-1}^{(0)} \\ \lambda_0^{(1)} & \lambda_1^{(1)} & \cdots & \lambda_{2t-1}^{(1)} \\ \vdots & \vdots & & \vdots \\ \lambda_0^{(2t-1)} & \lambda_1^{(2t-1)} & \cdots & \lambda_{2t-1}^{(2t-1)} \end{pmatrix} \cdot \begin{pmatrix} 1 & 1 & \cdots & 1 \\ \alpha^0 & \alpha^1 & \cdots & \alpha^{n-1} \\ \vdots & \vdots & & \vdots \\ \alpha^{0 \cdot (2t-1)} & \alpha^{1 \cdot (2t-1)} & \cdots & \alpha^{(n-1) \cdot (2t-1)} \end{pmatrix}$$

$$= \begin{pmatrix} \Lambda^{(0)}(\alpha^0) & \Lambda^{(0)}(\alpha^1) & \cdots & \Lambda^{(0)}(\alpha^{n-1}) \\ \Lambda^{(1)}(\alpha^0) & \Lambda^{(1)}(\alpha^1) & \cdots & \Lambda^{(1)}(\alpha^{n-1}) \\ \vdots & \vdots & & \vdots \\ \Lambda^{(2t-1)}(\alpha^0) & \Lambda^{(2t-1)}(\alpha^1) & \cdots & \Lambda^{(2t-1)}(\alpha^{n-1}) \end{pmatrix} \tag{19}.$$

It hence remains to find the polynomials $\Lambda^{(j)}(x) \in IF_q[x]$, $j = 0, ..., 2t\text{-}1$, to determine $\tilde{H}$.

From Eq. (11) it can be seen that the columns $\tilde{h}_{i_j}^T$ of $\tilde{H}$ at the parity locations $i_j$ $j = 0, ..., 2t - 1$, must reduce to canonical unit vectors $\underline{e}_j^T$,

$$\tilde{\underline{h}}_{i_j}^T = \begin{pmatrix} \Lambda^{(0)}(\alpha^{i_j}) \\ \Lambda^{(1)}(\alpha^{i_j}) \\ \vdots \\ \Lambda^{(2t-1)}(\alpha^{i_j}) \end{pmatrix} = \underline{e}_j^T, \qquad \text{where } \underline{e}_j = (\underbrace{0,\ldots,0}_{j},1,\underbrace{0,\ldots,0}_{2t\text{-}j\text{-}1}). \tag{20}$$

Hence, for $j = 0, ..., 2t - 1$, the polynomial $\Lambda^{(j)}(x)$ is the $j$-th Lagrange polynomial, i.e. the unique polynomial of degree $2t - 1$ from $IF_q[x]$ satisfying

$$\Lambda^{(j)}(\alpha^{i_k}) = \begin{cases} 1 & \text{for } k = j, \\ 0 & \text{for } k \neq j. \end{cases} \tag{21}$$

In order to find an expression for $\Lambda^{(j)}(x)$, first let

$$\Lambda(x) = \prod_{j=0}^{2t-1} \left(x - \alpha^{i_j}\right) \tag{22}$$

$$= \lambda_0 + \lambda_1 x + \ldots + \lambda_{2t-1} x^{2t-1} + x^{2t}$$

denote a monic polynomial of degree $2t$ in $IF_q[x]$ with $2t$ roots $\alpha^{i_j}$, $j = 0, ..., 2t - 1$. As the index $i_j$ defines the location of the parity symbol $P_j$ within the codeword $\tilde{\underline{c}}_{RS}$, the elements $\alpha^{i_j}$ will be called "parity locators" and the polynomial $\Lambda(x)$ "parity locator polynomial". Using this parity locator polynomial $\Lambda(x)$, the $j$-th Lagrange polynomial is given by

$$\Lambda^{(j)}(x) = \frac{\Lambda(x)}{(x - \alpha^{i_j}) \cdot \Lambda'(\alpha^{i_j})} \tag{23}$$

$$= \lambda_0^{(j)} + \lambda_1^{(j)} x + \ldots + \lambda_{2t-1}^{(j)} x^{2t-1},$$

where $\Lambda'(x)$ denotes the formal derivative of $\Lambda(x)$ in $IF_q[x]$,

$$\Lambda'(x) = \sum_{i=1}^{2t} i\lambda_i x^{i-1} \tag{24}$$

$$= \lambda_1 + \lambda_3 x^2 + \lambda_5 x^4 + \ldots + \lambda_{2t-1} x^{2t-2}.$$

The coefficients $\lambda_i^{(j)}$, $i,j = 0, \ldots, 2t\text{-}1$, of the polynomials $\Lambda^{(j)}(x)$ from Eq. (23) completely determine the inverse $\tilde{B}^{-1}$ of the Vandermonde matrix $\tilde{B}$. In his research article "Inverses of Vandermonde matrices", The American Mathematical Monthly 71, No. 4 (1964) 410/411, Parker used a similar idea for efficiently inverting Vandermonde matrices.

An expression for the parity symbols $P_j$ can now be found by combining the definition of Reed-Solomon codes given in Eq. (5) with the parity check matrix $\tilde{H}$ from Eq. (19),

$$\tilde{C}_{\mathrm{RS}} = \left\{ \underline{c} \in \mathrm{IF}_q^n : \tilde{H}\underline{c}^T = \underline{0} \right\}. \tag{25}$$

Since $H$ arises from $\underline{H}$ by means of a left multiplication with the matrix of full rank, the null space condition can be verified either for $H$ or for $\tilde{H}$. Due to Eq. (20), each parity symbol $P_j$ will appear only in the inner product of the $j$-th row of $\tilde{H}$ and the codeword $\underline{c}$, resulting in a linear system of equations,

$$\tilde{C}_{\mathrm{RS}} = \left\{ \underline{c} \in \mathrm{IF}_q^n : \sum_{\ell=0}^{n-1} \Lambda^{(j)}(\alpha^\ell) \cdot c_\ell = 0, \quad j = 0, \ldots, 2t - 1 \right\}. \tag{26}$$

In order to determine the parity symbols $P_j$, we may define a modified codeword vector

$$\hat{\underline{c}} = (I_0, I_1, 0, 0, I_3, I_4, \ldots, I_{k-2}, 0, I_{k-1}) \tag{27}$$

$$\uparrow \quad \uparrow \qquad\qquad\qquad \uparrow$$

$$\text{code locator index} = \qquad i_0 \quad i_1 \qquad\qquad\qquad i_{2t-1}$$

whose $\ell$-th entry $\hat{c}_\ell$ equals the data symbol at position $\ell$ of the desired codeword if $\ell$ does not denote the position of a parity symbol in said codeword, or equals zero if $\ell$ denotes the position of a parity symbol in said codeword. It is verified from Eq. (11) that the parity symbols $P_j$, $j = 0, \ldots, 2t - 1$, can be calculated using the expression

$$P_j = \sum_{\ell=0}^{n-1} \hat{c}_\ell \cdot \Lambda^{(j)}(\alpha^\ell). \tag{28}$$

A codeword $\underline{c} \in C_{Rs}$ will then result from correctly combining the data vector $\underline{I}$ with the parity symbols $P_j$ at the corresponding positions $i_j$. As apparent from Eq. (28), the determination of the parity symbol $P_j$ can hence be reduced to the evaluation of a polynomial $\Lambda^{(j)}$ of a degree that is no larger than the number of parity symbols in the codeword. Compared with the brute force approach of inverting the matrix $\tilde{B}$ in Eq. (13), this greatly simplifies the encoding: the storage requirements are significantly reduced, and it becomes possible to prepare codewords with parity symbols at arbitrary positions "on the fly", i.e., as the codewords are received at the encoding station.

The surprising realization that the determination of the parity symbols, and thus the preparation of the codewords, can be reduced to a simple evaluation of a polynomial of limited degree greatly enhances the efficiency of the encoding. It is a further finding of the inventors that the polynomial $\Lambda^{(j)}$ can be chosen as a Lagrange polynomial as defined in Eq. (21) above. Due to it simplified structure, this allows to further enhance the efficiency of the encoding circuit.

Plugging Eq. (23) into Eq. (28) leads to

$$P_j = \cdot \sum_{\ell=0}^{n-1} \hat{c}_\ell \cdot \frac{\Lambda(\alpha^\ell)}{(\alpha^\ell - \alpha^{i_j}) \cdot \Lambda'(\alpha^{i_j})} \qquad (29)$$

$$= \frac{1}{\Lambda'(\alpha^{i_j})} \cdot \sum_{\ell=0}^{n-1} \hat{c}_\ell \cdot \frac{\Lambda(\alpha^\ell)}{\alpha^\ell} \cdot \frac{1}{1 - \alpha^{i_j - \ell}}$$

The main advantage here is that the parity positions $i_j$, $j = 0, ..., 2t - 1$, are solely defined by the roots $\alpha^{ij}$ of the parity locator polynomial $\Lambda$ $(x)$, so it is sufficient to store the only $2 \cdot t$ coefficients from Eq. (22). The polynomial $\Lambda$ is seen not to depend on the parity symbol $P_j$, in the sense that $\Lambda$ depends merely on the parity pattern $\{i_j\}_{j=0, ...,2t-1}$ as a whole, but not on the respective parity position $i_j$ individually. As a result, the same polynomial $\Lambda$ can be employed to determine all the parity symbols $P_j$ of a given parity pattern $\{i_j\}_{j=0, ..., 2t-1}$. This allows to further simplify the determination of the parity symbols and to reduce the storage requirements. In the exemplary embodiment, it remains to store the $2 \times t = 20$ coefficients of the parity locator polynomial A for each of the 118 parity patterns under consideration. Hence, the storage requirements are reduced to

$$(118 \text{ patterns}) \times (20 \text{ coefficients/pattern}) \times (1 \text{ byte/coefficient}) = 2,360 \text{ bytes. } (30)$$

Compared to the 420,080 bytes of the brute-force approach according to Eq. (14), this amounts to a reduction by a factor of 187.

4. Hardware Implementation

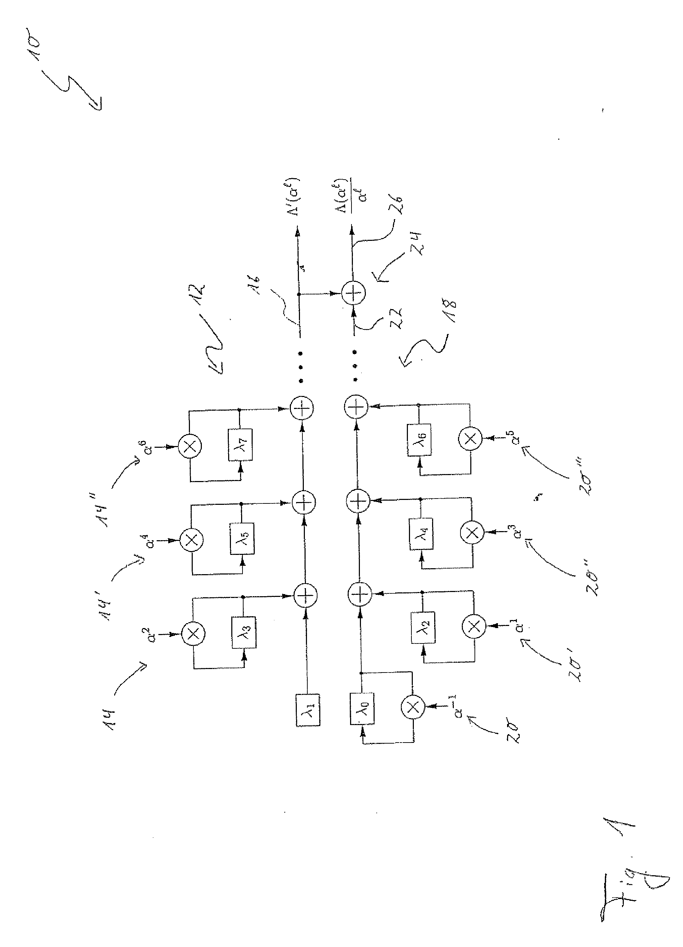

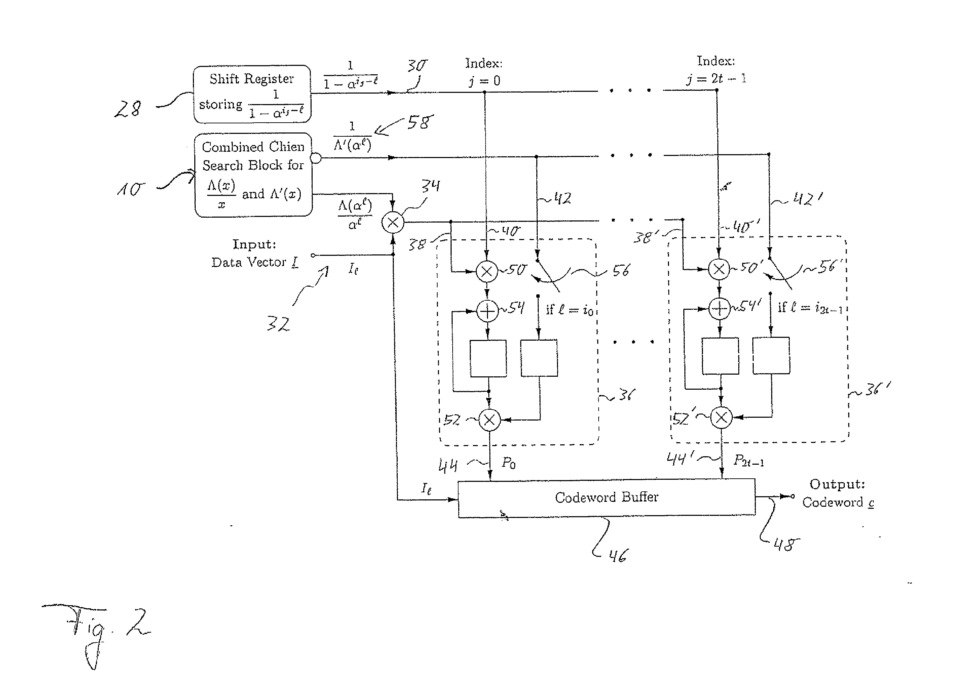

A hardware implementation of an encoding circuit according to the present invention will now be described with reference to Figs. 1 and 2.

An encoding station according to an embodiment of the invention receives, at a first input node, the data vector $\underline{I} = (I_0, I_1, ..., I_{k-1})$ containing the $k$ data symbols to be transmitted, and, at a second node, the parity pattern $\{i_j\}_{j=0, ..., 2xt-1}$ defining the positions at which the parity symbols $P_j$ are to be located within the codeword $\underline{\tilde{c}}_{RS}$. According to Eq. (28), the following terms are then required to calculate the parity symbols $P_j$:

1. the data vector $\underline{\hat{c}}$ with zero-padded parity positions according to Eq. (27),

2. the term $\dfrac{1}{1 - x}$ for any non-zero value $x \in IF_q$,

3. the term $\dfrac{1}{\Lambda'(x)}$, evaluated at $x = a^{ij}$, $j = 0, ..., 2t - 1$, as well as

4. the term $\dfrac{\Lambda(x)}{x}$, evaluated at $x = \alpha^\ell$, $\ell = 0, ..., n - 1$. x

The values of the term $\dfrac{1}{1-x}$, for $x \in IF_q \backslash \{0\}$, can be computed ahead of time and stored in a sequence of memory elements, for example in a shift register. Because each parity symbol $P_j$ evaluates this term at a different element $x = \alpha^{ij-\ell}$, all memory elements of such a shift register should be accessible at all times. Also, due to the arbitrary parity positions $i_j$, the sequence $\{\alpha^{ij-\ell}\}, \ell = 0, ..., n-1$, may take on all $q$ possible non-zero values of the field $IF_q$. Thus the shift register should be of size q-1. Additionally, the register containing the element with exponent $i_j$-$\ell$ =0 should preferably be set to 0 to prevent numerical instability and avoid additional logic switches.

The final step is to do an efficient evaluation of the terms $\dfrac{1}{\Lambda'(x)}$ at $x = \alpha^{ij}$, $j = 0, ..., 2t - 1$ and at $x = \alpha^\ell$, $\ell = 0, ..., n - 1$. For finite fields $IF_q$ with the restriction of the size $q = 2^m$, a comparison of the expressions for

$$\frac{\Lambda(x)}{x} = \lambda_0 x^{-1} + \lambda_1 + \lambda_2 x + \lambda_3 x^2 + \lambda_4 x^3 + ... + \lambda_{2t-1} x^{2t-2} + \lambda_{2t} x^{2t-1} \tag{31}$$

$$\Lambda'(x) = \qquad \lambda_1 \qquad + \lambda_3 x^2 \qquad + ... + \lambda_{2t-1} x^{2t-2} \tag{32}$$

yields that both terms share monomials of the form $\lambda_{2i+1} x^{2i}$ for $i = 0, ..., t-1$. As a result, the evaluation of the term $\Lambda'(x)$ is a byproduct of the evaluation of $\dfrac{\Lambda(x)}{x}$. The value of $\Lambda'(x)$ is x then simply inverted to get the value of $\dfrac{1}{\Lambda'(x)}$. A very efficient architecture for simultaneously evaluating A '(x) and $\dfrac{\Lambda(x)}{x}$ is a combined Chien search circuit as described in R. Chien, x "Cyclic Decoding Procedures for Bose-Chaudhuri-Hocquenghem Codes", IEEE Transactions on Information Theory, vol. 10, no. 4, pp. 357-363, Oct. 1964. If the memory elements are initialized with the coefficients $\lambda_0, ..., \lambda_{2t}$ of $\dfrac{\Lambda(x)}{x}$, this circuit will consecutively output the x values of $\dfrac{1}{\Lambda'(\alpha^\ell)}$ and $\dfrac{\Lambda(\alpha^\ell)}{\alpha^\ell}$ for $\ell = 0, ..., n-1$ with each clock cycle.

A Chien circuit 10 for evaluating the parity locator polynomial and its derivative is illustrated in Fig. 1. Circuit 10 comprises a first summing circuit 12 with a plurality of first registers 14, 14', 14", holding the even powers $\alpha^2, \alpha^4, \alpha^6$ etc. of the primitive element $\alpha$. Only three such first registers are shown in the illustration of Fig. 1. However, it is to be understood that the first summing circuit 12 comprises a sufficient number of first registers for all the even powers up to $\alpha^{2t-2}$.

As shown in Fig. 1, in the first summing circuit 12 these even powers $\alpha^2, \alpha^4$ $\alpha^6$ etc. are multiplied with the respective coefficients $\lambda_3, \lambda_5, \lambda_7$ etc. and are added to coefficient $\lambda_1$ to produce the value of the derivative $\Lambda'(x)$ of the parity locator polynomial according to Eq. (32) at a first output line 16.

Fig. 1 further shows a second summing circuit 18 with a second plurality of registers 20,20', 20", 20''' holding the odd powers $\alpha^{-1}, \alpha^1, \alpha^3, \alpha^5$ etc. of the primitive element $\alpha$. Only four such registers are depicted in the illustration of Fig. 1. However, it is to be understood that the second summing circuit comprises enough registers to store all of the odd powers necessary for the determination of $\Lambda(x)/x$ according to Eq. (31) above. The odd powers $\alpha^{-1}, \alpha^1, \alpha^3, \alpha^5$ etc. are multiplied with respective coefficients $\lambda_0, \lambda_2, \lambda_4, \lambda_6$ etc. and are added to produce an output at a second output line 22.

The third summing circuit 24 links the first output line 16 of the first summing circuit 12 to the second output line 22 of the second summing circuit 18, and is adapted to add the output of the first summing circuit 12 to the output of the second summing circuit 18. As is apparent from the description of the summing circuits as well as from Eq. (31) and (32), the third summing circuit 24 then outputs the value of $\dfrac{\Lambda(x)}{x}$ at a third output line 26. x

The architecture of the circuit thus makes efficient use of the fact that the terms $\frac{\Lambda(x)}{x}$ and $\Lambda\,'(x)$ share monomials of the even powers of x, and hence allows to evaluate both terms simultaneously. As a result, the parity symbols $P_j$ can be evaluated more quickly, and hence more efficiently.

A hardware circuit of an encoder according to an embodiment of the present invention will now be described with reference to Fig. 2. In the illustration of Fig. 2, reference numeral 10 denotes the combined Chien search circuit with first output line 16 and third output line 26, as described previously with reference to Fig. 1. An inverter 58 appended to the first output line 16 inverts the first output of the Chien circuit 10 to produce $\frac{1}{\Lambda'(\alpha^\ell)}$.

The encoder further comprises a shift register block 28 in which the values $\frac{1}{1-\alpha^{i_j-\ell}}$ are prestored and output on demand on a fourth output line 30 as well as an input node 32 for receiving the data vector $\underline{I}$ and a multiplier 34 for multiplying the value $\frac{\Lambda(\alpha^\ell)}{\alpha^\ell}$ with the corresponding element of input vector $\underline{\hat{c}}$ as defined in Eq. (27) above.

The encoder additionally has a plurality of parity locator circuits 36, 36' corresponding in number to the number $2t$ of parity symbols $P_j$ in the codeword. All these parity locator circuits share the same architecture, and hence Fig. 2 shows only two such circuits for the sake of clarity. The circuits 36, 36' comprise first input nodes 38, 38' connected to the output of the multiplier 34, second input nodes 40,40' connected to the fourth output line 30, and third input nodes 42, 42' connected to the first output line 14 of the Chien search block 10. By reading the respective outputs from the Chien search block 10 and the shift register 28 as well as from the multiplier 34, each of the parity locator circuits 36, 36' constitutes an implementation of Eq. (29) to determine the corresponding parity symbol $P_j$. The parity symbols $P_0$, ..., $P_{2t-1}$ thus determined are output at output nodes 44, 44', and are subsequently input, together with the data vector $I_l$, into a codeword buffer 46, which then yields the codeword vector $\underline{c}$ at an output node 48.

As can be seen by inspection of Eq. (29) as well as from the illustration of Fig. 2, each of the parity locator circuits 36, 36' can be implemented with merely two multipliers, one adder, and one selection switch each. A first multiplier 50, 50' is connected to the first input node 38, 38' and the second input note 40, 40', and is adapted to multiply the output of the shift register 28 with the output of multiplier 34. The adder 54, 54' is connected to the output of the first multiplier 50, 50' and serves to compute the sum in Eq. (29). The selection switch 56, 56' selects the corresponding value from the first output node 14 of the Chien search block 26, which is then multiplied at the second multiplier 52, 52' with the output of the adder 54, 54' to determine the parity symbol $P_j$.

Since both the Chien search block 26 and the shift register 28 likewise require only standard components, the encoder according to the present invention is efficient in terms of hardware and memory and can be easily implemented both in an integrated circuit or in a hardwired design. The hardware requirements for the implementation of a Reed-Solomon encoder according to an embodiment of the present invention are summarized in Table 1.

Table 1: Hardware Requirements

| Item | Description |
|---|---|
| Memory | - $q$ - 1 registers storing $\frac{1}{1-\alpha^{i_j-\ell}}$ |
| | - $2t$ + 1 registers in Chien search |
| | - $2t$ registers storing the values $\frac{1}{\Lambda'(\alpha^{i_j})}$ |
| | -2t registers in summation |
| | - $n$ registers for codeword buffer |
| Adders | - $2t$ adders in Chien search |
| | - $2t$ adders in summation |
| Multipliers | - $2t$ constant multipliers in Chien search |
| | - $2t$ + 1 variable multipliers for parity symbols |

(continued)

| Item | Description |
|---|---|
| | - 2*t* variable multipliers for normalization |
| Inverters | - 1 inverter for $\dfrac{1}{\Lambda'(\alpha^{i_j})}$ after Chien search |
| Logic Switches | - 2*t* logic switches to select $\dfrac{1}{\Lambda'(\alpha^{i_j})}$ |

The description and the figures merely serve to illustrate the invention and its numerous advantages, and should not be understood to restrict or limit the invention in any way. The scope of the invention is determined solely by the appended set of claims.

**Claims**

1. A method of encoding data for transmission from a source to a destination over a communication channel by means of an error-correcting code, said error-correcting code being defined by a parity check matrix (*H*) having a Vandermonde structure, the method comprising the steps of:

   receiving a plurality of data symbols ($I_\ell$); and
   preparing at least one codeword (c) of said error-correcting code at an encoding station, said codeword to be transmitted over said communication channel and comprising said plurality of data symbols ($I_l$) and a plurality of parity symbols ($P_j$);
   wherein said step of preparing said codeword (c) comprises the steps of:

   selecting one out of a plurality of parity patterns (${\{i_j\}}_{j=0,...,2t-1}$), said parity pattern (${\{i_j\}}_{j=0,...,2t-1}$) determining the positions at which said parity symbols ($P_j$) are located within said codeword (c); and
   determining said parity symbols ($P_j$) on the basis of said data symbols ($I_\ell$) and said selected parity pattern (${\{i_j\}}_{j=0,...,2t-1}$);
   **characterized in that** determining at least one of said parity symbols ($P_j$) is based on a step of evaluating a polynomial ($\Lambda^{(j)}$, $\Lambda$) of a degree that is no larger than the number of parity symbols *($P_j$)* in said codeword (c).

2. The method according to claim 1, wherein said polynomial ($\Lambda^{(j)}$) is a Lagrange polynomial, i.e.,

$$\Lambda^{(j)}(\alpha^{i_k}) = \begin{cases} 1 \ for \ k = j, \\ 0 \ for \ k \neq j, \end{cases}$$

wherein $\alpha$ denotes a primitive element of a finite field,*j* is a positive integer denoting the parity symbol, and $i_k$ is a positive integer denoting the position of the *k*-th parity symbol in said codeword according to said selected parity pattern.

3. The method according to claim 1 or 2, wherein the *j*-th parity symbol is determined by evaluating the equation

$$P_j = \sum_{\ell=0}^{n-1} \hat{c}_\ell \cdot \Lambda^{(j)}(\alpha^\ell)$$

for every parity symbol $P_j$, wherein *n* denotes the length of said codeword, $\Lambda^{(j)}$ denotes a polynomial of a degree that is no larger than the number of parity symbols in said codeword (c), $\alpha$ denotes a primitive element of a finite

field, and $\hat{c}_\ell$ equals the data symbol at position $\ell$ of said codeword ($c$) if $\ell$ does not denote a position of a parity symbol in said codeword (c), or equals $0$ if $\ell$ denotes a position of a parity symbol in said codeword (c).

4.  The method according to claim 1 or 2, wherein said step of determining said parity symbols ($P_j$) comprises a step of evaluating said polynomial ($\Lambda$), and further evaluating its derivative ($\Lambda$'), said polynomial (A) being independent of said parity symbols ($P_j$).

5.  The method according to claim 4, wherein said step of determining said parity symbols ($P_j$) comprises a step of evaluating a ratio of said polynomial ($\Lambda$) at an element of a finite field and said element itself, and further evaluating said derivative ($\Lambda$') of said polynomial ($\Lambda$).

6.  The method according to claim 4 or 5, wherein said plurality of parity symbols ($P_j$) are solely defined in terms of the roots of said polynomial ($\Lambda$) and the position of the parity symbol within said codeword.

7.  The method according to any of the preceding claims, wherein the $j$-th parity symbol $(P_j)$ is determined by evaluating the equation

$$P_j = \frac{1}{\Lambda'(\alpha^{i_j})} \cdot \sum_{\ell=0}^{n-1} \hat{c}_\ell \cdot \frac{\Lambda(\alpha^\ell)}{\alpha^\ell} \cdot \frac{1}{1-\alpha^{i_j-\ell}}$$

for every parity symbol $P_j$, wherein $n$ denotes the length of said codeword, $\Lambda$ denotes a polynomial of a degree that is no larger than the number of parity symbols in said codeword, said polynomial A being independent of said parity symbols $P_j$, $\alpha$ denotes a primitive element of a finite field, A' denotes the first derivative of $\Lambda$, $i_j$ is a positive integer denoting the position of the $j$-th parity symbol in said codeword, and $\hat{c}_\ell$ equals the data symbol at position $\ell$ of said codeword if $\ell$ does not denote a position of a parity symbol in said codeword, or equals $0$ if $\ell$ denotes a position of a parity symbol in said codeword.

8.  The method according to any of the preceding claims, wherein said parity symbols ($P_j$) are not arranged in a single block at the beginning or at the end of said codeword (c).

9.  The method according to any of the preceding claims, wherein said parity symbols ($P_j$) are determined by means of a Chien search.

10. A storage medium storing instructions readable by a computing device, such that the computing device, when executing said instructions, implements the method according to any of the preceding claims.

11. An encoder for encoding data to be transmitted from a source to a destination over a communication channel by means of an error-correcting code, said error-correcting code being defined by a parity check matrix ($H$) having a Vandermonde structure, said encoder comprising:

    encoding means adapted to receive a plurality of data symbols ($I_\ell$) and to prepare at least one codeword (c) of said error-correcting code, said codeword (c) to be transmitted over said communication channel and comprising said plurality of data symbols ($I_\ell$) and a plurality of parity symbols $(P_j)$; and
    pattern selection means adapted to select one out of a plurality of parity patterns ($\{i_j\}_{j=0,...,2t-1}$), said parity pattern ($\{i_j\}_{j=0,...,2t-1}$) determining the positions at which said parity symbols $(P_j)$ are located within said codeword ($c$);
    **characterized in that** said encoder is adapted to determine said parity symbols ($P_j$) on the basis of said data symbols ($I_\ell$) and said selected parity pattern ($\{i_j\}_{j=0,...,2t-1}$) by evaluating a polynomial ($\Lambda^{(j)}$, $\Lambda$) of a degree that is no larger than the number of parity symbols ($P_j$) in said codeword (c).

12. The encoder according to claim 11, wherein said encoder is adapted to determine said parity symbols ($P_j$) by evaluating said polynomial ($\Lambda$) and further evaluating its derivative ($\Lambda$), said polynomial (A) being independent of said parity symbols ($P_j$).

13. The encoder according to claim 12, wherein said encoder is adapted to determine said parity symbols ($P_j$) by evaluating a ratio of said polynomial (A) at an element of a finite field and said element itself, and further evaluating

said derivative ($\Lambda$) of said polynomial ($\Lambda$).

14. The encoder according to any of the claims 11 to 13 with a first summing circuit (12), a second summing circuit (18), and a third summing circuit (24), said third summing circuit (24) connecting an output line (16) of said first summing circuit (12) to an output line (22) of said second summing circuit (18), wherein said first summing circuit (12) comprises a plurality of first registers (14, 14', 14") adapted to hold a plurality of even powers of a primitive element ($\alpha$) of a finite field and a corresponding number of first coefficients ($\lambda_1, \lambda_3, \lambda_5, \lambda_7$), said second summing circuit (18) comprises a plurality of second registers (20, 20', 20", 20''') adapted to hold a plurality of odd powers of said primitive element ($\alpha$) and a corresponding number of second coefficients ($\lambda_0, \lambda_2, \lambda_4, \lambda_6$), and said third summing circuit (24) is adapted to add an output of said first summing circuit (12) to an output of said second summing circuit (18).

15. The encoder according to claim 14, further comprising an inversion circuit (58) adapted to invert the output of said first summing circuit (12).

Fig. 1

EP 2 309 649 A1

Shift Register storing $\dfrac{1}{1-\alpha^{i_j-\ell}}$   28

$\dfrac{1}{1-\alpha^{i_j-\ell}}$   30

Index: $j=0$

Index: $j=2t-1$

$\dfrac{1}{\Lambda'(\alpha^\ell)}$   58

Combined Chien Search Block for $\dfrac{\Lambda(x)}{x}$ and $\Lambda'(x)$   10

$\dfrac{\Lambda(\alpha^\ell)}{\alpha^\ell}$   34

Input: Data Vector $\underline{I}$   32

$I_\ell$

~42   ~42′

~40   ~40′

38   38′

~50   ~56

~50′   ~56′

~54   if $\ell=i_0$

~54′   if $\ell=i_{2t-1}$

~36   ~36′

52   52′

44   $P_0$   44′   $P_{2t-1}$

$I_\ell$

Codeword Buffer   46

Output: Codeword $\underline{c}$   48

Fig. 2

Europäisches
Patentamt

European
Patent Office

Office européen
des brevets

**EUROPEAN SEARCH REPORT**

Application Number

EP 09 17 1077

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 2003/099303 A1 (BIRRU DAGNACHEW [US] ET AL) 29 May 2003 (2003-05-29) | 1,8, 10-11 | INV. H03M13/15 |
| A | * paragraphs [0003], [0005], [0059], [0060], [0064] * <br> * figure 7 * | 2-7, 12-15 | |
| Y | S. Lin and D. Costello: "Error Control Coding" 2004, Pearson Education International , Upper Saddle River, NJ, USA , XP002571455 ISBN: 0130179736 | 1,8, 10-11 | |
| A | * page 240 * <br> * page 263 - page 264 * | 2-7, 12-15 | |
| A | EP 0 584 864 A1 (KONINKL PHILIPS ELECTRONICS NV [NL]) 2 March 1994 (1994-03-02) * page 2, line 3 - line 22 * * page 3, line 31 - page 5, line 41 * * figures 1-7 * | 1-15 | |

TECHNICAL FIELDS
SEARCHED        (IPC)

H03M

The present search report has been drawn up for all claims

| Place of search | Date of completion of the search | Examiner |
|---|---|---|
| Munich | 4 March 2010 | Burkert, Frank |

EPO FORM 1503 03.82 (P04C01)

## ANNEX TO THE EUROPEAN SEARCH REPORT
## ON EUROPEAN PATENT APPLICATION NO.

EP 09 17 1077

This annex lists the patent family members relating to the patent documents cited in the above-mentioned European search report.
The members are as contained in the European Patent Office EDP file on
The European Patent Office is in no way liable for these particulars which are merely given for the purpose of information.

04-03-2010

| Patent document cited in search report | Publication date | Patent family member(s) | Publication date |
|---|---|---|---|
| US 2003099303 A1 | 29-05-2003 | NONE | |
| EP 0584864 A1 | 02-03-1994 | NONE | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- ATSC-M/H Standard, Part 2, RF/Transmission System Characteristics (A/1 53, Part 2: 2009). Advanced Television Systems Committee, 2009
- Inverses of Vandermonde matrices. The American Mathematical Monthly, 1964, vol. 71, 410, 411
- **R. Chien.** Cyclic Decoding Procedures for Bose-Chaudhuri-Hocquenghem Codes. *IEEE Transactions on Information Theory,* October 1964, vol. 10 (4), 357-363